Europäisches Patentamt

European Patent Office

Office européen des brevets

(19)

(11) Publication number: **0 119 617**
**B1**

(12)

# EUROPEAN PATENT SPECIFICATION

(45) Date of publication of patent specification: 25.05.88

(51) Int. Cl.⁴: **H 05 K 1/03, H 01 B 3/40**

(21) Application number: **84102950.7**

(22) Date of filing: **16.03.84**

(54) Flame retarded epoxy resin composition for use in the manufacture of electrical laminates.

(30) Priority: **17.03.83 JP 45537/83**
**26.10.83 JP 201223/83**

(43) Date of publication of application:
**26.09.84 Bulletin 84/39**

(45) Publication of the grant of the patent:
**25.05.88 Bulletin 88/21**

(84) Designated Contracting States:
**BE DE FR GB IT NL**

(56) References cited:
**EP-A-0 014 444**
**EP-A-0 047 534**
**US-A-3 202 947**
**US-A-4 372 800**

(73) Proprietor: **KANEGAFUCHI KAGAKU KOGYO**
**KABUSHIKI KAISHA**
**2-4 Nakanoshima 3-chome**
**Kita-ku Osaka-shi Osaka-fu (JP)**

(72) Inventor: **Fushiki, Yasuo**
**21-1-437 Ohatacho**
**Takatsuki-shi Osaka-fu (JP)**
Inventor: **Oizumi, Masayuki**
**1-22 Hieitsuji 2-chome**
**Otsu-shi Shiga-ken (JP)**
Inventor: **Abe, Masaharu**
**12-18-104 Okamoto 7-chome**
**Higashinada-ku Kobe (JP)**

(74) Representative: **Kinzebach, Werner, Dr.**
**Patentanwälte Reitstötter, Kinzebach und**
**Partner Sternwartstrasse 4 Postfach 86 06 49**
**D-8000 München 86 (DE)**

Courier Press, Leamington Spa, England.

**Description**

Background of the invention
This invention relates to a flame retarded epoxy resin composition for use in the manufacture of electrical laminates and a process for producing flame retarded electrical laminates using said resin.

The term "electrical laminate" as used herein refers to unclad insulation boards for mounting various electrical and electronic components thereon as well as one or both sided metal clad laminates for use in the manufacture of printed circuit boards.

Epoxy based electrical laminates have been conventionally produced by impregnating a substrate sheet such as glass cloth, glass paper, cellulosic paper and the like with a resin varnish in a volatile solvent, drying the substrate to obtain a prepreg, stacking a plurality of prepregs together, optionally placing a cladding metal foil on one or both sides of the stack, and then pressing the stack at a temperature of about 170°C at a pressure above about 40 kg/cm$^2$.

The above conventional process naturally exhibits a low productivity due to its batchwise nature and requires a large amount of investments to solvent removal and recovery systems and hot presses.

Oizumi et al, U.S. Patent No. 4,372,800 issued February 8, 1983 and assigned to the assignee of this application discloses a process for continuously producing electrical laminates wherein the substrate is impregnated with a solvent-free, normally liquid epoxy resin composition which comprises an epoxy resin and a liquid acid anhydride hardener. This composition is capable of curing without generation of gaseous or liquid byproducts. After the impregnation, a plurality of substrates are combined, sandwiched between a pair of covering sheets and then cured without molding pressure.

In order to apply the above process to the production of flame retarded epoxy based laminates, it is imperative that the flame retarded epoxy resin composition to be employed be normally liquid without solvent and have a suitable viscosity level for readily impregnating reinforcing substrates. However, flame retardent halogen-containing epoxy resins normally occur as a solid or semi-solid having very high viscosity levels. Liquid resin compositions having desired viscosity levels may be prepared by dissolving the solid or semi-solid resin in a liquid hardener such as liquid acid anhydride hardeners. However, since the liquid acid anhydride hardeners are inflammable, relatively large amounts of halogen-containing epoxy resins should be mixed with a given amount of the hardener or the halogen content of the epoxy resin should be increased to achieve a desired degree of flame retardance in the entire composition. Experiments have shown, however, that the use of an excess of halogen-containing epoxy resins or the use of high halogen-content epoxy resins tends to compromise other requisite properties, such as mechanical, electrical and thermal properties required in finished laminates. Sometimes the combined compositions are too viscous to impregnate the substrate or too expensive to manufacture.

It is, therefore, a major object of the present invention to overcome the above-discussed problems. Other objects and advantages thereof will become apparent as the description proceeds.

Summary of the invention
According to the present invention, there is provided a solvent-free, liquid, flame retarded epoxy resin composition suitable for use in impregnating a fibrous substrate of flame retarded electrical laminates.

The composition has a viscosity level at which the substrate may be readily impregnated, and is capable of imparting a desired degree of flame retardance to the finished laminate without compromising other properties of the laminate.

The composition of the present invention comprises a halogen-containing epoxy resin, a liquid acid anhydride hardener and a phosphorus-containing flame retardant additive. Preferably, the composition also contains an antimony oxide as an enhancing agent.

In a preferred embodiment, said liquid acid anhydride hardener is a liquid eutectic mixture of HET anhydride with a liquid dibasic acid anhydride such as methylhexahydrophthalic anhydride, methyltetrahydrophthalic anhydride or methyl Nadic anhydride.

Preferably about 40 to 110 parts by weight of said liquid acid anhydride hardener are combined per 100 parts by weight of the halogen-containing epoxy resin, and the entire composition preferably contains about 10 to about 30% of halogen, about 0.05 to about 1.4% of elementary phosphorus, and optionally about 0.5 to about 8% of said antimony oxide based on the total weight of the composition.

The present invention also provides a process for continuously producing electrical laminates comprising the steps of, all in continuous mode, impregnating a fibrous substrate with the solvent-free, normally liquid, flame retarded epoxy resin composition of the present invention, combining a plurality of impregnated substrates into a unitary laminate, applying a pair of covering sheets onto both sides of the laminate, and curing the laminate. Preferably the laminate includes at least one layer of a substrate made of glass fiber which is pretreated with a mercapto silane coupling agent.

Detailed description of invention
The halogen-containing epoxy resin used in the present invention may be of commercially available types. Examples thereof include halogenated bisphenol A epoxy resins, halogenated novolac epoxy resins, dibromoneopentyl alcohol epoxy resins and the like. The term "halogen" used herein refers to chlorine and bromine, particularly bromine. Tetrabromobisphenol A epoxy resin is especially preferred.

The halogen-containing epoxy resin may be blended with a halogen-free epoxy resin such as liquid bisphenol A epoxy resin or liquid novolac epoxy resin for adjusting the halogen content and/or for preparing a liquid blend. The halogen-containing epoxy resin may also be prepared by the addition of an additive type organohalide flame retardant and/or monofunctional halogen-containing epoxide to a halogen-free epoxy resin and/or halogen-containing epoxy resin.

Examples of liquid acid anhydride hardeners include normally liquid dibasic acid anhydride such as methylhexahydrophthalic anhydride, methyltetrahydrophthalic anhydride, methyl Nadic anhydride and mixtures of these acid anhydrides. Also included are solutions or eutectic mixtures of a normally solid polybasic acid anhydride such as hexahydrophthalic anhydride, tetrahydrophthalic anhydride, trimellitic anhydride and pyromellitic anhydride with the above-mentioned normally liquid dibasic acid anhydrides. Preferably the liquid acid anhydride hardener also contains a halogen. To this end HET anhydride, which is a normally solid, chlorine-containing dibasic acid anhydride, may form a eutectic mixture with a liqiud dibasic acid anhydride such as methylhexahydrophthalic anhydride, methyltetrahydrophthalic anhydride, methyl Nadic anhydride and the like. The proportions of these components vary with the particular liquid acid anhydride used. Typically HET anhydride may be blended with methyltetrahydrophthalic anhydride within the range from 6:4 to 1:9. The use of HET anhydride in this manner contributes to increased halogen contents and thus increased flame retardance of the entire resin composition.

The ratio of the liquid acid anhydride hardener relative to a given amount of the halogen-containing epoxy resin may vary with the epoxy equivalent of the particular epoxy resin. Generally 40 to 110 parts, preferably 50 to 90 parts by weight of the hardener are used per 100 parts by weight of the epoxy resin.

The phosphorus-containing flame retardant additive may be organophosphates, halogenated organophosphates or other organophosphorus compounds. Examples of preferred organophosphates include tricresyl phosphate, trioctyl phosphate, triphenyl phosphate, trixylenyl phosphate, octyl diphenyl phosphate, cresyl diphenyl phosphate and the like.

Antimony oxides such as antimony tri- or pentoxide may be added in combination with the phosphorus-containing flame retardant additive for further enhancing the flame retardency of the composition without compromising mechanical, electrical and other properties thereof. Finely divided antimony tri- or pentoxide having an average particle size less than 0.05 μm may be added particularly when a transparent composition is desired.

In order that the desired degree of flame retardance is compatible with the desired performance characteristics in the finished laminate, the resin composition of the present invention should have a total halogen content from 10 to 30%, preferably from 12 to 25%, more preferably from 15 to 22% by weight of the entire composition, preferably in terms of the sum of the bromine content available in the epoxy resin and the chlorine content available in the hardener.

The content of phosphorus-containing flame retardent additive generally ranges from 0.05 to 1.4%, preferably 0.08 to 0.5%, more preferably 0.1 to 0.3% by weight of the entire composition as elementary phosphorus.

The content of antimony oxides, if used, generally ranges less than 8%, preferably less than 5%, more preferably from 1.2 to 3% by weight of the entire composition.

The liquid epoxy resin composition of the present invention should have a viscosity from 1 to 30 poise, preferably 2 to 15 poise for use in impregnating a fibrous substrate without diluting with a solvent. The composition may, of course, contain other conventional additives such as pigments, fillers, hardening accelerators such as tertiary amines, internal mold release and other additives as desired.

In use, a fibrous substrate or reinforcing member is impregnated with the liquid resin composition of the present invention. A plurality of resin-impregnated substrates are combined and a pair of covering sheets are applied onto both sides of the resulting laminate. Then the laminate is cured, for example, by passing through a tunnel oven. The entire operation is preferably carried out in a continuous mode as described in the hereinbefore cited U.S. patent. One or both of the pair of covering sheets may be a cladding metal foil which eventually becomes a permanent member of metal clad laminates for use in the manufacture of printed circuit boards. Otherwise the covering sheet or sheets may be stripped from the cured laminate. The curing should be continued at least until the laminate is non-tacky and self-supporting. Thereafter continuous length of semi- or fully cured laminate may be cut into segments of practical size and subjected to post-curing, if necessary, and other processing.

Examples of substrates include glass fiber substrates such as glass paper and glass cloth, cellulosic substrates such as kraft paper and cotton linter paper, and synthetic fiber substrates such as nylon® cloth and polyester cloth. These substrates may be used individually or in combination. For example, a glass cloth substrate may be used for outermost layers with remainder being glass paper and/or cellulosic paper substrates. This combination gives a laminate having satisfactory mechanical and electrical properties capable of forming through holes by punching.

Preferably, prior to the impregnation, glass fiber substrates are treated with, for example, a silane or chromium coupling agent and cellulosic substrates are treated with a methylol compound such as phenol resin or melamine resin. This treatment is effective to improve anti-moisture characteristics of the finished laminate.

In a particularly preferred embodiment, the laminate includes at least one layer of glass fiber substrate

3

which has been pretreated with a mercapto silane coupling agent prior to the impregnation with the resin composition of the present invention.

Heretofore, amino silanes or epoxy silanes have been conventional for treating glass fiber substrates. It has been discovered that these treating agents are not fully effective to increase the affinity of glass fiber substrates with epoxy resin compositions particularly when an acid hydride hardener is used. Mercapto silanes are remarkably effective for said purpose compared with other treating agents and greatly increase anti-moisture characteristics of the finished laminate.

Typical examples of mercapto silanes include γ-mercaptopropyl-trimethoxy silane and its homologs. They may be applied at a pick up amount of 0.03—3%, preferably 0.05—1.5%, more preferably 0.1—1.0% by weight of the substrate by conventional methods such as spraying or dipping.

Examples of covering sheets include various release papers, cellophane, plastic films such as Teflon® or polyester films, and metal foils such as aluminum, copper, stainless steel or phosphor bronze foils. They may be of 10—200 µm thickness and have a coating of a mold release on the side facing the laminate.

Examples of cladding metal foils include electrolytic copper or iron foils, and rolled copper, iron or aluminum foils. Electrolytic copper foils are widely used. These cladding foils eventually become an integral part of printed circuit board stock material and therefore require to have a predetermined peel strength. Accordingly, it is preferable for these cladding foils to have a coating of an adhesive on the side facing the laminate.

The laminate and metal clad laminate produced by the process of the present invention may comply with high standards of performance characteristics required for electrical uses. They exhibit a high flame retardance (e.g. Vo under UL standard) as well as good heat resistance, mechanical strength, dimension stability, resistivity and solder dip strength.

The following examples will illustrate the present invention. All parts and percents therein are by weight.

Example 1

A flame retarded epoxy resin composition is prepared from 42 parts of a brominated bisphenol A epoxy resin (EPIKOTE 1050, Shell Chemical, Br content 44—48%), 58 parts of a bisphenol A epoxy resin (EPIKOTE 828, Shell Chemical), 73 parts of an eutectic mixture of methylhexahydrophthalic anhydride and HET anhydride (4:1), 6 parts of tricresyl phosphate and 4 parts of antimony trioxide.

8 plies of a commercial glass cloth which has been pretreated with an epoxy silane (Nippon Unicar, A-187) are individually and continuously impregnated with the above resin composition and combined together into a unitary sheet. An electrolytic copper foil of 35 µm thickness having a coating of a silane coupling agent (Nippon Unicar, A-1100) is applied on both sides of the laminate sheet with the coated side of copper foil facing the laminate sheet. The entire structure is then cured at 130°C for 50 minutes continuously and then at 140°C for 6 hours after cutting into segments of practical size. A two sided copper clad laminate having a thickness of about 1.6 mm is obtained. Properties of the resulting laminate are shown in Table 1.

Example 2

The process of Example 1 is repeated except that a glass cloth substrate is used only for two outermost layers and the remaining four layers are replaced by a kraft paper substrate pretreated with a melamine resin. The resulting two sided copper clad laminate exhibited a good punchability at room temperature. Other properties are shown in Table 1.

Example 3

The process of Example 1 is repeated except that the commercial glass cloth is pretreated with a mercapto silane (Nippon Unicar, A-189). Properties of the resulting laminate are shown in Table 1.

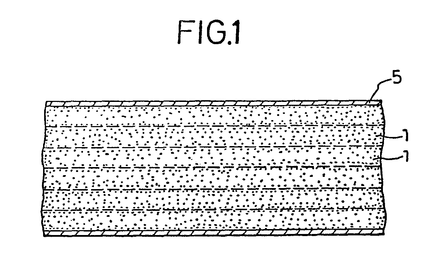

The enclosed Figure 1 shows an electrical laminate according to the invention. A plurality of impregnated substrates (1) is combined to a unitary laminate to which a pair of covering sheets (5) is applied.

TABLE 1
Properties of laminates

| Item | Condition | Example 1 | Example 2 | Example 3 |
|---|---|---|---|---|
| Solder dip resistance | C-96/20+D-1/100 | >120 sec. | 77 sec. | >120 sec. |
| Flex strength (lateral) | C-96/20/65 | 45 kg/mm$^2$ | 31 kg/mm$^2$ | 49 kg/mm$^2$ |
| Resistivity | C-96/20/65 +D-2/100 | $8.7\times10^{12}$ Ohm | $5.2\times10^{12}$ Ohm | $2.7\times10^{14}$ Ohm |
| Flame retardancy | A | Vo | Vo | Vo |

Solder dip resistance, flex strength and resistivity were determined according to JIS C6481. Flame retardance was determined by UL 94.

## Claims

1. A flame retarded epoxy resin composition for use in the manufacture of flame retarded electrical laminates which comprises a halogen-containing epoxy resin, a liquid acid anhydride hardener, and a phosphorus-containing flame retardant additive, said composition being solvent-free and liquid.

2. The composition of Claim 1 further comprising an antimony oxide.

3. The composition of Claim 2, wherein said liquid acid anhydride hardener is combined in a proportion of 40 to 110 parts by weight per 100 parts by weight of said halogen-containing epoxy resin.

4. The composition of Claim 3, wherein said liquid acid anhydride hardener is a eutectic mixture of HET anhydride with a liquid dibasic acid anhydride.

5. The composition of Claim 4, wherein said liquid dibasic acid anhydride is methylhexahydrophthalic anhydride, methyltetrahydrophthalic anhydride or methyl Nadic anhydride.

6. The composition of Claim 5, wherein the total halogen content of said composition is about 10% to about 30% by weight.

7. The composition of Claim 6, wherein said total halogen content is the sum of the bromine content available in said halogen-containing epoxy resin and the chlorine content available in said liquid acid anhydride hardener.

8. The composition of Claim 2, wherein said phosphorus-containing flame retardant additive is present in an amount of about 0.05 to about 1.4% by weight as elementary phosphorus.

9. The composition of Claim 2, wherein said antimony oxide is present in an amount of about 0.5 to about 8% by weight.

10. The composition of Claim 9, wherein said antimony oxide is antimony trioxide.

11. A process for continuously producing electrical laminates comprising the steps of, all in continuous mode, impregnating a fibrous substrate with the resin composition of any one of Claims 1—10, combining a plurality of impregnated substrates into a unitary laminate, applying a pair of covering sheets onto both sides of the laminate, and curing the laminate.

12. The process of Claim 11, wherein at least one of said pair of covering sheets is a cladding metal foil which is permanently bonded to the laminate.

13. The process of Claim 12, wherein at least one of said plurality of substrates is made of glass fiber.

14. The process of Claim 13, wherein said substrate made of glass fiber is pretreated with a mercapto silane prior to the impregnation.

15. The process of Claim 14, wherein said mercapto silane is γ-mercaptopropyl-trimethoxysilane.

16. The process of Claim 12, wherein at least one of said plurality of substrates is made of cellulosic fiber.

17. The process of Claim 16, wherein said substrate made of cellulosic fiber is pretreated with a methylol compound prior to the impregnation.

18. The process of Claim 12, wherein outermost layers of said pluraltiy of substrates are made of glass fiber and the remaining layers of said plurality of substrates are made of cellulosic fiber and/or glass paper.

19. The process of Claim 12, wherein said resin composition has a total halogen content of about 10 to about 30%, a phosphorus content of about 0.05 to about 1.4%, and an antimony oxide content of about 0.5 to 8% by weight of the entire resin composition.

## Patentansprüche

1. Flammhemmende Epoxyharz-Zusammensetzung für die Herstellung von schwer entflammbaren elektrischen Laminaten, die ein halogenhaltiges Epoxyharz, einen flüssigen Säureanhydridhärter und ein phosphorhaltiges flammhemmendes Additiv enthält und die lösungsmittelfrei und flüssig ist.

2. Zusammensetzung nach Anspruch 1, die außerdem ein Antimonoxid enthält.

3. Zusammensetzung nach Anspruch 2, wobei der flüssige Säureanhydridhärter in einem Verhältnis von 40 bis 110 Gewichtsteile pro 100 Gewichtsteile halogenhaltigem Epoxyharz vorliegt.

4. Zusammensetzung nach Anspruch 3, wobei der flüssige Säureanhydridhärter eine eutektische Mischung aus HET-Anhydrid und einem flüssigen dibasischen Säurenhydrid ist.

5. Zusammensetzung nach Anspruch 4, wobei das flüssige dibasische Säureanhydrid Methylhexahydrophthalsäureanhydrid, Methyltetrahydrophthalsäureanhydrid oder Methylnadicsäure-anhydrid ist.

6. Zusammensetzung nach Anspruch 5, wobei der Gesamtgehalt an Halogen der Zusammensetzung ungefähr 10 bis ungefähr 30 Gew.-% beträgt.

7. Zusammensetzung nach Anspruch 6, wobei der Gesamtgehalt an Halogen die Summe aus dem Gehalt an Brom im halogenhaltigen Epoxyharz und dem Gehalt an Chlor im flüssigen Säureanhydrid härter ist.

8. Zusammensetzung nach Anspruch 2, wobei das phosphorhaltige flammhemmende Additiv in einer Menge von ungefähr 0,05 bis ungefähr 1,4 Gew.-%, berechnet als elementarer Phosphor, vorliegt.

9. Zusammensetzung nach Anspruch 2, wobei das Antimonoxid und einer Menge von ungefähr 0,5 bis ungefähr 8 Gew.-% vorliegt.

10. Zusammensetzung nach Anspruch 9, wobei das Antimonoxid Antimontrioxid ist.

11. Verfahren zur kontinuierlichen Herstellung von elektrischen Laminaten, wobei man kontinuierlich ein Fasersubstrat mit der Harzzusammensetzung nach einem der Ansprüche 1 bis 10 imprägniert, mehrere imprägnierte Substrate zu einem Einheitslaminat kombiniert, zwei Deckblätter auf beiden Seiten des Laminats anbringt und das Laminat härtet.

12. Verfahren nach Anspruch 11, wobei mindestens eines der zwei Deckblätter eine kaschierte Metallfolie ist, die permanent an das Laminat gebunden ist.

13. Verfahren nach Anspruch 12, wobei mindestens eines der Substrate aus Glasfaser gefertigt ist.

14. Verfahren nach Anspruch 13, wobei das Substrat aus Glasfaser vor der Imprägnierung mit Mercaptosilan vorbehandelt wird.

15. Verfahren nach Anspruch 14, wobei das Mercaptosilan γ-Mercaptopropyltrimethoxysilan ist.

16. Verfahren nach Anspruch 12, wobei mindestens eines der Substrate aus Cellulosefaser gefertigt ist.

17. Verfahren nach Anspruch 16, wobei das Substrat aus Cellulosefaser vor der Imprägnierung mit einer Methylolverbindung vorbehandelt wird.

18. Verfahren nach Anspruch 12, wobei die äußeren Schichten der Substrate aus Glasfaser und die übrigen Schichten der Substrate aus Cellulosefaser und/oder Glaspapier bestehen.

19. Verfahren nach Anspruch 12, wobei die Harzzusammensetzung einen Gesamtgehalt an Halogen von ungefähr 10 bis ungefähr 30 Gew.-%, einen Phosphorgehalt von ungefähr 0,05 bis ungefähr 1,4 Gew.-% und einen Antimonoxidgehalt von ungefähr 0,5 bis 8 Gew.-% besitzt, bezogen auf die gesamte Harzzusammensetzung.

## Revendications

1. Composition ignifugée de résine époxyde utilisable pour fabriquer des stratifiés électriques ignifugés, comprenant une résine époxyde halogénée, un durcisseur anhydride d'acide liquide, et un additif phosphoré retardateur de flamme, cette composition étant liquide et exempte de solvant.

2. Composition selon revendication 1, comprenant en outre un oxyde d'antimoine.

3. Composition selon revendication 2, dans laquelle ledit durcisseur anhydride d'acide liquide est combiné en proportion de 40 à 110 parties en poids pour 100 parties en poids de ladite résine époxyde halgénée.

4. Composition selon revendication 3, dans laquelle ledit durcisseur anhydride d'acide liquide est un mélange eutectique d'anhydride HET et d'un anhydride d'acide dibasique liquide.

5. Composition selon revendication 4, dans laquelle ledit anhydride d'acide dibasique liquide est l'anhydride méthylhexahydrophthalique, l'anhydride méthyltétrahydrophtalique, ou un anhydride méthyl nadique.

6. Composition selon la revendication 5, dans laquelle la teneur totale en halogène de ladite composition est d'environ 10% à environ 30% en poids.

7. Composition selon revendication 6, dans laquelle la teneur totale en halogène est la somme de la teneur du brome présent dans ladite résine époxyde halogénée et de la teneur du chlore présent dans ladite durcisseur anhydride d'acide liquide.

8. Composition selon revendication 2, dans laquelle ledit additif phosphoré retardateur de flamme est présent en quantité d'environ 0,05 à environ 1,4% en poids de phosphore élémentaire.

# 0 119 617

9. Composition selon revendication 2, dans laquelle ledit oxyde d'antimoine est présent en quantité d'environ 0,5 à environ 8% en poids.

10. Composition selon revendication 9, dans laquelle ledit oxyde d'antimoine est le trioxyde d'antimoine.

11. Procédé de production en continu de stratifiés électriques, comportant les étapes suivantes, toutes en mode continu: imprégnation d'un substrat fibreux par la composition de résine selon l'une quelconque des revendications 1 à 10, combinaison d'une pluralité de substrats imprégnés en un stratifié unitaire, application d'une paire de feuilles de revêtement sur les deux côtés du stratifié, et cuisson du stratifié.

12. Procédé selon revendication 11 dans lequel au moins une feuille de ladite paire de feuilles de revêtement est une feuille métallique de placage qui est liée de manière permanente au stratifié.

13. Procédé selon revendication 12 dans lequel au moins un substrats de ladite pluralité de substrat est en fibres de verre.

14. Procédé selon revendication 13, dans lequel ledit substrat en fibres de verre est prétraité avec un mercapto-silane avant l'imprégnation.

15. Procédé selon revendication 14, dans lequel ledit mercaptosilane est le γ-mercaptopropyl-triméthoxylsilane.

16. Procédé selon revendication 12, dans lequel au moins un substrat de ladite pluralité de substrats est en fibres cellulosiques.

17. Procédé selon revendication 16, dans lequel ledit substrat en fibres cellulosiques est prétraité avec un composé de méthylol avant l'imprégnation.

18. Procédé selon revendication 12, dans lequel les couches les plus externes de ladite pluralité de substrats sont en fibres de verre et les couches de substrats restant en fibres cellulosiques et/ou en papier de verre.

19. Procédé selon revendication 12, dans lequel ladite composition de résine possède une tenur totale d'halogène d'environ 10 à environ 30%, une tenur de phosphore d'environ 0,05 à environ 1,4% et une teneur d'oxyde d'antimoine d'environ 0,5 à 8% en poids de la composition totale de résine.

7

# FIG.1